# EUROPÄISCHE PATENTANMELDUNG

(11) **EP 2 403 094 A2**
(43) Veröffentlichungstag der Anmeldung: **04.01.2012**
(21) Anmeldenummer: 11171650.2
(22) Anmeldetag: 28.06.2011
(51) Int. Cl.: H02J 3/46, H03K 17/687, B60R 16/03, H02J 1/14

(54) **Elektronisches Ansteuersystem zur Steuerung der Leistungsaufnahme mehrerer elektrischer Verbraucher**

(30) Priorität: 01.07.2010 DE 102010030816; 27.10.2010 DE 102010049800
(71) Anmelder: DBK David + Baader GmbH, 76870 Kandel (DE)
(72) Erfinder: Scholl, Dietmar, 67295 Bolanden (DE); Uhl, Günter, 74921 Helmstadt-Bargen (DE)
(74) Vertreter: Winter, Brandl, Fürniss, Hübner, Röss, Kaiser, Polte - Partnerschaft

(57) **Zusammenfassung**

Offenbart wird ein elektronisches Ansteuersystem zur Steuerung der Leistungsaufnahme mehrerer, an ein gemeinsames Energieversorgungsnetz angeschlossener elektrischer Verbraucher, bei dem für jeden elektrischen Verbraucher eine eigene elektronische Schalteinrichtung vorgesehen ist, die die jeweilige Leistungsaufnahme des angeschlossenen Verbrauchers durch eine Pulsweitenmodulation individuell steuert. Die Erfindung sieht vor, die ansteigende Flanke der pulsweitenmodulierten Ausgangsspannung einer jeweiligen Schalteinrichtung so mit der absteigenden Flanke der Ausgangsspannung einer anderen Schalteinrichtung zu synchronisieren, dass infolge der Überlappung der beiden Flanken im Energieversorgungsnetz nur eine minimale Stromflanke auftritt. Weiterhin können auch solche prozentuelle Leistungswerte der Verbraucher, die nicht diskreten Stufen entsprechen, dadurch bereitgestellt werden, dass in zeitlicher Folge die diskreten Stufen so geändert werden, dass den Verbrauchern im zeitlichen Mittel die jeweils gewünschte prozentuelle Leistung zugeführt wird.

## Beschreibung

Die Erfindung bezieht sich auf ein elektronisches Ansteuersystem zur Steuerung der Leistungsaufnahme mehrerer, an ein gemeinsames Energieversorgungsnetz angeschlossener elektrischer Verbraucher gemäß dem Oberbegriff des Anspruchs 1. Gegenstand der Erfindung ist ferner ein entsprechendes Ansteuerungsverfahren gemäß Anspruch 10.

Elektronische Ansteuersysteme, mit denen die Leistungsaufnahme von mehreren elektrischen Verbrauchern, die an ein gemeinsames Energieversorgungsnetz angeschlossen sind, individuell geregelt werden kann, sind im Stand der Technik hinlänglich bekannt. Zu diesem Zweck wird für jeden elektrischen Verbraucher eine eigene Leistungs-Halbleiter-Schalteinrichtung, beispielsweise in Form eines MOSFET-Schalters, vorgesehen, die die jeweilige Leistungsaufnahme des angeschlossenen Verbrauchers, z.B. in Abhängigkeit von den Schaltbefehlen eines zentralen Mikrocontrollers, individuell steuern kann.

Zur eigentlichen Steuerung der Leistungsaufnahme der Verbraucher wird vorzugsweise eine Pulsweitenmodulation (PWM) eingesetzt, bei der der jeweilige MOSFET-Schalter nur in den Schaltzuständen EIN und AUS betrieben wird und lediglich das Tastverhältnis die Leistung des Verbrauchers steuert. Diese bekannte PWM-Ansteuerung hat den Vorteil, dass die Verlustleistung der Schaltelemente minimiert werden kann. Diese Minimierung geht darauf zurück, dass die Verlustleistung in den Schaltelementen hauptsächlich durch ihren Durchgangswiderstand definiert wird. Gleichwohl entsteht durch den Schaltvorgang eine zusätzliche Verlustleistung, und zwar in Abhängigkeit von der Steilheit der Schaltflanke.

Ein Nachteil dieses bekannten PWM-Ansteuerungsverfahrens liegt jedoch darin, dass die relativ steilen Flanken der pulsweitenmodulierten Ausgangsspannungen der MOSFET-Schalter zu entsprechend starken Stromflanken führen, die das Energieversorgungsnetz auch verkraften muss bzw. die keine negativen Auswirkungen auf andere Verbraucher haben sollten. Insbesondere bei Bordnetzen für Kraftfahrzeuge stellen derartige Stromflanken ein Problem dar: einerseits gibt es dort relativ sensible Verbraucher, die vor jeder Spannungsschwankung geschützt sein sollten, während andererseits das Bordnetz in seiner Stromlieferfähigkeit begrenzt ist, so dass Stromflanken bestimmter Stärke unvermeidlich zu Spannungsschwankungen führen würden. Eine wesentliche Anforderung an ein typisches Hochvolt-Bordnetz, welches in einem Nennspannungsbereich von 150V bis 460V arbeitet, ist daher darin zu sehen, dass die Stromflanken aufgrund ihrer Störbeeinflussung des Bordnetzes auf ein Minimum beschränkt werden müssen.

Aus der EP 1 986 322 A1 ist eine PWM-Ansteuerschaltung bekannt, bei der vorgeschlagen wird, die jeweiligen Teillasten bzw. Verbraucher phasenversetzt anzusteuern; hierdurch wird vermieden, dass mehrere Stromflanken zusammenfallen, so dass das Energieversorgungsnetz im Mittel lediglich mit der von einem einzigen Verbraucher hervorgerufenen Stromflanke belastet wird, nicht jedoch mit einer Summe aus mehreren Stromflanken. Da bei diesem bekannten System die Stromflanken jedoch sehr häufig bzw. mit hoher Frequenz auftreten, ist es bei empfindlichen Bordnetzen nur mit Einschränkungen verwendbar.

In der EP 1 511 150 A1 wird ein Verfahren zum pulsweitenmodulierten Ansteuern mehrerer Verbraucher beschrieben, bei dem die Pulsmodulationen so koordiniert werden, dass sich die dem Netz entnommenen Leistungsimpulse möglichst wenig überlappen, so dass die dem Netz entnommene Spitzenbelastung minimal wird. Bei diesem bekannten Verfahren kann die gewünschte Verteilung der Ansteuerimpulse jedoch nur dadurch erreicht werden, dass zu jedem Zeitpunkt nur ein einziger Verbraucher einen Leistungsimpuls erhält. Die Regelbarkeit der einzelnen Verbraucher ist hierdurch erheblich eingeschränkt, insbesondere ist es nicht möglich, alle Verbraucher gleichzeitig mit Maximalleistung zu betreiben.

Die EP 1 692 014 B1 offenbart schließlich ein PWM-Ansteuerungsverfahren für mehrere Verbraucher, bei dem die einzelnen Verbraucher zeitlich versetzt angesteuert werden, d.h. insbesondere auch die Einschaltflanken der Verbraucher sind zeitlich versetzt, so dass sich auch deren hochfrequente Störungen nicht addieren, sondern über die Zeit verteilen. Bei bestimmten Verhältnissen von Anzahl der Verbraucher (bzw. Phasen) und Tastverhältnis kann mit diesem bekannten Verfahren die dem Netz eingeprägte Störung daher auf ein Minimum verringert werden (beispielsweise bei 16 Phasen und einem Tastverhältnis von 50 %). Nachteilig bei diesem Verfahren ist es jedoch, dass die Flexibilität bei der Regelung der einzelnen Verbraucher ebenfalls stark eingeschränkt ist.

Der Erfindung liegt die Aufgabe zugrunde, ein elektronisches Ansteuersystem gemäß dem Oberbegriff des Anspruchs 1 so weiterzubilden, dass unter Beibehaltung einer guten Regelbarkeit der Verbraucher belastende Stromflanken für das Energieversorgungsnetz weitgehend vermieden werden können. Aufgabe der Erfindung ist es ferner, ein entsprechendes Ansteuerungsverfahren anzugeben.

Diese Aufgabe wird hinsichtlich des Ansteuersystems mit den kennzeichnenden Merkmalen des Anspruchs 1 und hinsichtlich des Verfahrens mit den kennzeichnenden Verfahrensschritten des Anspruchs 10 gelöst.

Mit der Erfindung wird erreicht, dass die ansteigende Flanke der pulsweitenmodulierten Ausgangsspannung für einen elektrischen Verbraucher so mit der absteigenden Flanke der Ausgangsspannung für einen anderen Verbraucher synchronisiert werden kann, dass infolge der Überlappung der beiden Flanken im Energieversorgungsnetz nur eine minimale Stromflanke auftritt. Mit der Erfindung wird dadurch erreicht, dass sich die beiden Flanken quasi kompensieren, so dass das Energieversorgungsnetz durch diesen Schaltvorgang strommäßig so gut wie nicht belastet wird. Negative Auswirkungen durch den PWM-Schaltvorgang auf andere Verbraucher sind somit ausgeschlossen; hierdurch kann die erfindungsgemäße Ansteuerung problemlos auch bei entsprechend sensiblen Versorgungsnetzen wie insbesondere bei Bordnetzen für Kraftfahrzeuge verwendet werden.

Der Nachteil dieser Regelung, dass die Verbraucher nur in den durch ihre Anzahl vorgegebenen diskreten Leistungsstufen betrieben werden können, wird erfindungsgemäß dadurch beseitigt, dass solche prozentuelle Leistungswerte der Verbraucher, die nicht den diskreten Leistungsstufen entsprechen, bereitgestellt werden, indem in zeitlicher Folge die diskreten Stufen so geändert werden, dass den Verbrauchern im zeitlichen Mittel die jeweils gewünschte prozentuelle Leistung zugeführt wird. Beispielsweise kann bei drei Verbrauchern, bei denen gemäß der vorstehenden Erläuterung die diskreten Leistungsstufen 0%, 33%, 66% und 100% zur Verfügung stehen, die Leistungsstufe 50% dadurch bereitgestellt werden, dass über einen vorgegebenen Zeitraum abwechselnd so zwischen den Leistungsstufen 33% und 66% hin- und hergeschaltet wird, dass innerhalb des vorgegebenen Zeitraums jeweils die gleiche Anzahl von 33%- und 66%-Leistungsstufen vorliegt.

Die Erfindung ermöglicht somit eine optimale, nahezu beliebige Regelung der Verbraucher unter gleichzeitiger minimaler Belastung des Versorgungsnetzes.

Die in der Praxis verwendeten elektronischen Schalter in Form von MOSFET- oder IGBT-Schaltern haben den Nachteil, dass sich ihre Einschalt- und Ausschaltverzögerung insbesondere in Abhängigkeit von ihrer Betriebstemperatur zeitlich ändert. Um dadurch hervorgerufene negative Auswirkungen auf die von der Erfindung geforderte Flankensynchronisation zu verhindern, wird gemäß Anspruch 2 vorgeschlagen, die sich ändernde Einschalt- und Ausschaltverzögerung dynamisch zu überwachen und bei der Wahl des Einschalt- bzw. Ausschaltzeitpunkts der jeweiligen Schalteinrichtung so zu berücksichtigen, dass die Überlappung der Flanken möglichst synchron ist.

Bei der erfindungsgemäßen Ansteuerung treten in der Praxis lediglich beim Umschalten von einer diskreten Leistungsstufe auf die andere kurze Stromflanken auf. Der Einfluss dieser Stromflanken auf das Versorgungsnetz kann erfindungsgemäß jedoch verringert werden, indem gemäß der Lehre des Anspruchs 3 mindestens eine der Schalteinrichtungen mit mindestens zwei verschiedenen Flankensteilheiten schaltbar ist, wobei die Schaltvorgänge im Normalfall mit einer hohen Flankensteilheit (d.h. schneller) durchgeführt werden, während ein Schaltvorgang zum Ändern einer diskreten Leistungsstufe mit einer niedrigen Flankensteilheit (d.h. langsamer) durchgeführt wird. Die sich dadurch ergebende etwas höhere Verlustleistung wird von der Erfindung bewusst In Kauf genommen, da die sich hierdurch verringernde Rückwirkung auf das Versorgungsnetz als weitaus positiverer Effekt erweist. Da die mit der niedrigen Flankensteilheit durchgeführten Umschaltvorgänge zudem wesentlich seltener auftreten als die zyklisch wiederholten, steilflankigen Umschaltungen innerhalb einer Leistungsstufe, sind die Schaltverluste in der Praxis zudem ohne große Bedeutung.

Bezüglich noch weiterer Vorteile der Erfindung wird auf die anderen Unteransprüche verwiesen.

Die Erfindung wird nachstehend anhand der Beschreibung eines Ausführungsbeispiels unter Bezugnahme auf die Zeichnung näher erläutert. Es zeigen:
Fig. 1 ein Blockschaltbild eines erfindungsgemäßen Ansteuersystems zum Betrieb von drei Heizelementen;
Fig. 2a den Verlauf der PWM-Ansteuerspannungen und den daraus resultierenden Stromfluss bei den Leistungsstufen 0%, 33%, 66% und 100%;
Fig. 2b ein der Fig. 2a entsprechendes Diagramm, bei dem eine der Schalteinrichtungen mit zwei verschiedenen Flankensteilheiten geschaltet wird;
Fig. 3a ein Verfahren, bei dem durch zyklisches Umschalten der diskreten Leistungsstufen eine Ausgangsleistung von 50% realisiert wird;
Fig. 3b ein Verfahren, bei dem durch zyklisches Umschalten der diskreten Leistungsstufen eine Ausgangsleistung von 80% realisiert wird;
Fig. 4a ein Verfahren zur Bereitstellung der Leistungsstufe 50% bei dem Ausführungsbeispiel der Fig. 2a;
Fig. 4b ein Diagramm, das die in einem zeitlichen Raster von 6 Sekunden bei einer Taktfrequenz von 1 Sekunde erzielbaren prozentuellen Leistungswerte angibt; und
Fig. 5 ein Verfahren zur Kompensation von thermisch bedingten Änderungen der Ein- und Ausschaltverzögerung der verwendeten MOSFET-Schalter;

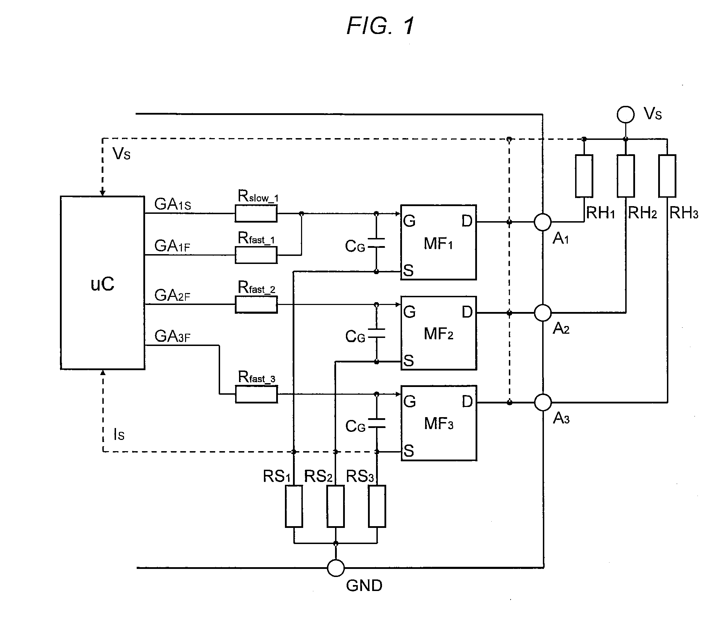

Als Ausführungsbeispiel der Erfindung wird nachstehend anhand der Fig. 1 eine Ansteuerschaltung bzw. ein Ansteuersystem beschrieben, das zur Ansteuerung bzw. zur Leistungsregelung von drei Heizelementen RH₁ bis RH₃ dient, die an ein nicht näher gezeigtes Energieversorgungsnetz in Form des Bordnetzes V_{S} eines Kraftfahrzeugs angeschlossen sind; im Falle eines Hochvolt- Bordnetzes liegt dabei eine Versorgungsspannung V_{S} von beispielsweise 350 V an. Es versteht sich, dass die Erfindung auch für andersgeartete Verbraucher sowie für andere Netze verwendbar ist.

Gemäß Fig. 1 ist das erfindungsgemäße Ansteuersystem über drei zur Strommessung dienende Shuntwiderstände RS₁ bis RS₃ mit Massepotential GND verbunden. Drei Ausgangsanschlüsse A₁ bis A₃ des Ansteuersystems sind mit einem ersten Anschluss eines jeweils zugeordneten Heizelements RH₁ bis RH₃ verbunden, an deren anderem Anschluss die Spannung des Bordnetzes V_{S} anliegt. Zwischen dem Masse abgewandten Anschluss jedes der Shuntwiderstände RS₁ bis RS₃ und einem zugeordneten Ausgangsanschluss A₁ bis A₃ ist eine elektronische Schalteinrichtung in Form eines Leistungs-MOSFET-Schalters MF₁ bzw. MF₂ bzw. MF₃ geschaltet; der jeweilige Ausgangsanschluss ist mit dem zugeordneten Drain D des zugeordneten Leistungs-MOSFET-Schalters verbunden. Somit wird das erste Heizelement RH₁ über den Leistungs-MOSFET-Schalter MF₁ angesteuert, das zweite Heizelement RH₂ über den Leistungs-MOSFET-Schalter MF₂ und das dritte Heizelement RH₃ über den Leistungs-MOSFET-Schalter MF₃.

Die Ansteuerung der Leistungs-MOSFET-Schalter MF₁ bis MF₃ bzw. die geeignete Bereitstellung ihrer Gate-Ansteuerspannungen übernimmt eine Steuervorrichtung in Form eines Mikrocontrollers µC, der den Leistungs-MOSFET-Schaltern MF₁ bis MF₃ über Vorwiderstände R_{slow_1} (bzw. R_{fast_1}), R_{fast_2} bzw. R_{fast_3} ein jeweils individuelles Gate-Ansteuersignal GA_{1S} (bzw. GA_{1F}), GA_{2F} bzw. GA_{3F} zuführt. Zur geeigneten Bereitstellung der Gate-Ansteuersignale werden dem Mikrocontrollers µC ferner die Versorgungsspannung des Bordnetzes V_{S} und ein Signal I_{S} zugeführt, das den jeweils erfassten Strom repräsentiert. Mit C_{G} ist jeweils die (parasitäre) Kapazität bezeichnet, die sich zwischen dem Gate G und der Source S des jeweiligen Leistungs-MOSFET-Schalters befindet.

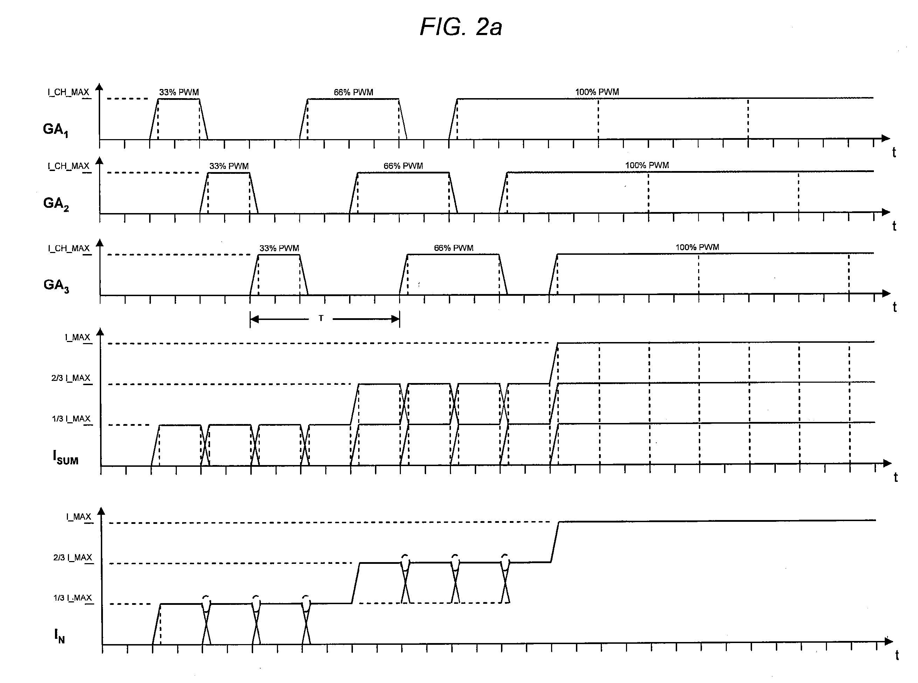

Die den drei Heizelementen zuzuführende Leistung wird durch geeignete Einstellung des Tastverhältnisses der individuellen Gate-Ansteuersignale GA_{1S} (bzw. GA_{1F}), GA_{2F} bzw. GA_{3F} gesteuert (siehe z.B. Fig. 2a), d.h. es handelt sich um eine bekannte Pulsweitenmodulation (PWM), in der die Leistungs-MOSFET-Schalter MF₁, MF₂ und MF₃ den höchsten Wirkungsgrad erreichen. Wie aus der Fig. 1 ferner zu erkennen ist, kann das Gate G des Leistungs-MOSFET-Schalters MF₁ sowohl über den Vorwiderstand R_{slow_1} als auch über den Vorwiderstand R_{fast_1} angesteuert werden, je nachdem, ob das Signal GA_{1S} oder GA_{1F} aktiv ist. Der Wert des Vorwiderstands R_{fast_1} ist ebenso wie der der Vorwiderstände R_{fast_2} und R_{fast_3} so gewählt, dass die parasitäre Kapazität C_{G} schnellstmöglich entladen wird, so dass der zugehörige Leistungs-MOSFET-Schalter schnellstmöglich, d.h. mit der größtmöglichen Flankensteilheit einschaltet. Bei dieser Art der Einschaltung tritt im Leistungs-MOSFET-Schalter die geringste Verlustleistung auf. Der Vorwiderstand R_{slow_1} hat demgegenüber einen höheren Widerstandswert, so dass die Entladung der parasitären Kapazität C_{G} entsprechend länger dauert; die Flankensteilheit beim Einschalten des Leistungs-MOSFET-Schalters ist daher bei Verwendung des Vorwiderstands R_{slow_1} geringer, der Einschaltvorgang dauert folglich länger und ist mit einer größeren Verlustleistung verbunden. Der Leistungs-MOSFET-Schalter MF₁ muss daher für eine größere Verlustleistung ausgelegt sein und/oder besser gekühlt werden als die anderen Schalter. Der Einschaltvorgang über den Vorwiderstand R_{slow_1} hat andererseits den Vorteil, dass die niedrigere Flankensteilheit eine geringere Auswirkung auf das Energieversorgungsnetz V_{S} hat.

Wenn auch die beiden anderen Leistungs-MOSFET-Schalter MF₂ und MF₃ mit unterschiedlichen Flankensteilheiten geschaltet werden sollen, müssen für diese ebenfalls entsprechende Vorwiderstände vorgesehen werden und sie müssen für die höhere Verlustleistung ausgelegt sein und entsprechend gekühlt werden. Wenn nicht nur zwei sondern noch mehr unterschiedliche Flankensteilheiten für einen oder alle Leistungs-MOSFET-Schalter bereitgestellt werden sollen, so kann dies sehr einfach durch entsprechend viele Vorwiderstände mit geeignet gewählten Widerstandswerten erreicht werden.

Es sei angemerkt, dass anstelle von MOSFET-Schaltern auch IGBT-Schalter oder andere geeignete Leistungs-Halbleiterschalter verwendet werden können.

Die erfindungsgemäße Arbeitsweise des in Fig. 1 gezeigten Ansteuersystems wird nachfolgend zunächst unter Bezugnahme auf das in Fig. 2a gezeigte Impulsdiagramm näher erläutert.

In Fig. 2a sind in den oberen drei Strom/Zeitdiagrammen die Ströme gezeigt, die durch Anlegen des ersten individuellen Gate-Ansteuersignals GA_{1F} in dem ersten Heizelement RH₁, durch Anlegen des zweiten individuellen Gate-Ansteuersignals GA_{2F} in dem zweiten Heizelement RH₂ bzw. durch Anlegen des dritten individuellen Gate-Ansteuersignals GA_{3F} in dem dritten Heizelement RH₃ fließen. Im von oben gesehen vierten Strom/Zeitdiagramm der Fig. 2a ist der sich durch die Ansteuerung der drei Heizelemente ergebende Summenstrom I_{SUM} gezeigt und das untere Strom/Zeitdiagramm verdeutlicht den sich daraus ergebenden Strom I_{N} im Energieversorgungsnetz V_{S}.

Gemäß Fig. 2a befindet sich das System am Anfang im Zustand der Leistungsstufe 0, d.h. alle drei Heizelemente sind ausgeschaltet. In einer sich daran anschließenden ersten Aufwärmphase wird dann allen drei Heizelementen ein Gate-Ansteuersignal mit einer Pulsweite (bzw. Impulsbreite) von 33% zugeführt; in dieser Leistungsstufe 1 liegt an allen drei Heizelementen folglich ein Drittel der Maximalleistung an. In einer nachfolgenden Phase wird dann allen drei Heizelementen ein Gate-Ansteuersignal mit einer Pulsweite von 66% zugeführt; so dass sie in dieser Leistungsstufe 2 mit zwei Dritteln der Maximalleistung arbeiten. In der letzten Leistungsstufe 3 arbeiten die drei Heizelemente dann mit voller Leistung, da ihnen ein ununterbrochenes Gate-Ansteuersignal (Pulsweite = 100%) zugeführt wird.

Gemäß der Lehre der Erfindung werden alle Gate-Ansteuersignale mit einem Phasenversatz von 120 Grad erzeugt. Dadurch wird in Verbindung mit der gewählten Impulsbreite von 33% bzw. 66% erreicht, dass z.B. die ansteigende Flanke der Ausgangsspannung des zweiten MOSFET-Schalters MF₂ so mit der absteigenden Flanke der Ausgangsspannung des ersten MOSFET-Schalters MF₁ zusammenfällt bzw. überlappt, dass infolge der Überlappung der beiden Flanken im Energieversorgungsnetz V_{S} nur eine minimale Stromflanke auftritt, wie aus den beiden unteren Stromdiagrammen unmittelbar ersichtlich ist. In ebensolcher Weise fällt die ansteigende Flanke der Ausgangsspannung des dritten MOSFET-Schalters MF₃ mit der absteigenden Flanke der Ausgangsspannung des zweiten MOSFET-Schalters MF₂ zusammen; dieses Schema gilt analog auch für die ansteigende Flanke der Ausgangsspannung des ersten MOSFET-Schalters MF₁ und die absteigende Flanke der Ausgangsspannung des dritten MOSFET-Schalters MF₃.

Das erfindungsgemäße Schaltschema des vordefinierten Verhältnisses der Impulsbreiten bzw. Pulsweiten und des vorbestimmten Phasenversatzes führt auch dazu, dass beim Umschalten von einer Leistungsstufe auf die nächst höhere (bzw. beim Umschalten auf die nächst niedrigere) als maximale Stromflanke ein Wert auftritt, der dem Unterschied der beiden Leistungen entspricht (siehe die beiden unteren Stromdiagramme der Fig. 2a).

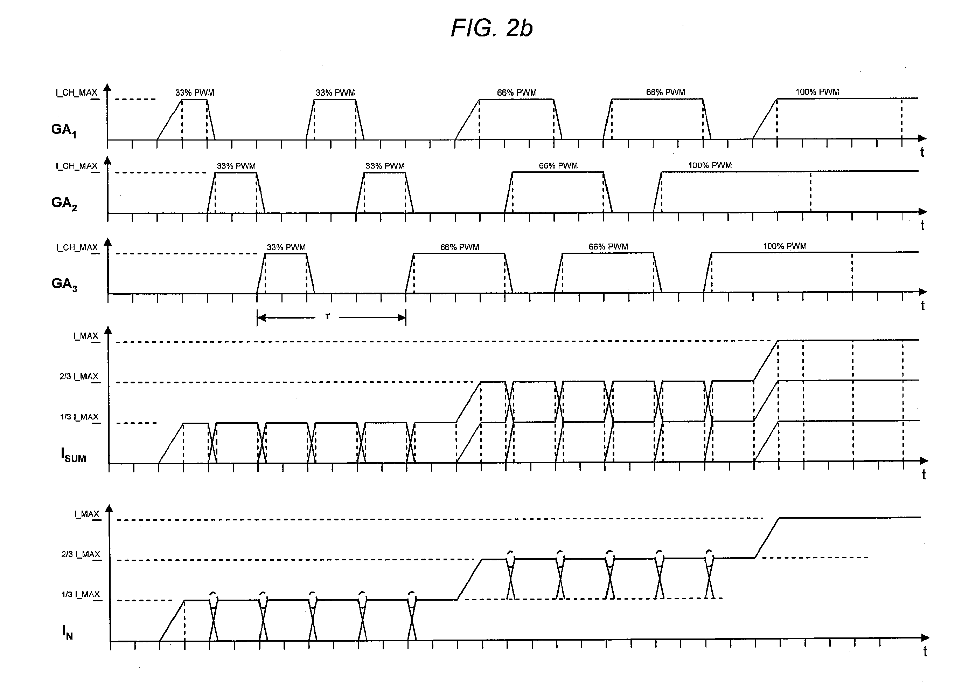

Um die negative Auswirkung der beim Umschalten der Leistungsstufen auftretenden Stromflanke auf das Energieversorgungsnetz V_{S} zu verringern, kann die Ansteuerung nach dem in Fig. 2b gezeigten Schema erfolgen. Wie aus einem Vergleich dieser Figur mit der Fig. 2a unmittelbar ersichtlich ist, erfolgt bei diesem Ausführungsbeispiel die Ansteuerung des Leistungs-MOSFET-Schalters MF₁ mit den beiden unterschiedlichen Ansteuersignalen GA_{1S} bzw. GA_{1F} dergestalt, dass beim Umschalten von einer Leistungsstufe auf die nächst höhere (bzw. beim Umschalten auf die nächst niedrigere) das Ansteuersignal GA_{1S} verwendet wird, so dass sich bei diesem Schaltvorgang jeweils eine flachere Anstiegsflanke einstellt (siehe die ansteigende Flanke des ersten, dritten und fünften Impulses der oberen Diagrammzeile). Die anderen Impulse, bei denen keine Änderung der Leistungsstufe vorliegt, werden demgegenüber mittels des Ansteuersignals GA_{1F} eingeschaltet, so dass ihre Anstiegsflanke entsprechend steil und damit wenig verlustbehaftet ist. Wie aus den beiden unteren Stromdiagrammen der Fig. 2b zu erkennen ist, erfolgt die Umschaltung der Leistungsstufen weniger abrupt als im Falle des Ausführungsbeispiels der Fig. 2a, was zu den erwähnten positiven Auswirkungen auf das Energieversorgungsnetz V_{S} führt.

Wenn, wie im Falle des gezeigten Ausführungsbeispiels, die Umschaltung der Leistungsstufen immer mit dem gleichen Leistungs-MOSFET-Schalter begonnen und beendet wird, genügt es, nur für diesen Leistungs-MOSFET-Schalter mindestens zwei verschiedene Flankensteilheiten vorzusehen und nur diesen Leistungs-MOSFET-Schalter entsprechend stärker zu dimensionieren und/oder zu kühlen. Falls eine andere Art der Umschaltung der Leistungsstufen erwünscht ist, können je nach Bedarf auch die anderen Leistungs-MOSFET-Schalter mit der Möglichkeit der Schaltung mit mindestens zwei verschiedenen Flankensteilheiten versehen werden.

Wenn das erfindungsgemäße Ansteuersystem zum Betrieb von lediglich zwei Heizelementen vorgesehen ist und demgemäß nur zwei MOSFET-Schalter benötigt werden, wird nur eine mittlere Leistungsstufe vorgesehen, bei der die Impulsbreite 50% beträgt. Der Phasenversatz würde in diesem Fall 180 Grad betragen. Zum Betrieb von vier Heizelementen werden vier MOSFET-Schalter benötigt und es werden drei mittlere Leistungsstufen vorgesehen, bei denen die jeweilige Impulsbreite 25%, 50% bzw. 75% beträgt. Der Phasenversatz würde in diesem Fall 90 Grad betragen. Wenn man die Anzahl der zu betreibenden Heizelemente mit **N** bezeichnet, ergeben sich zum Betrieb eines erfindungsgemäßen Ansteuersystems allgemein folgende Werte:
Anzahl der MOSFET-Schalter: **N**
Anzahl der mittleren Leistungsstufen: **N - 1**
Tastverhältnis bzw. Größe der Impulsbreite der **x**-ten Leistungsstufe: **(100/ N) * x %** Phasenversatz: **(360 / N) Grad**

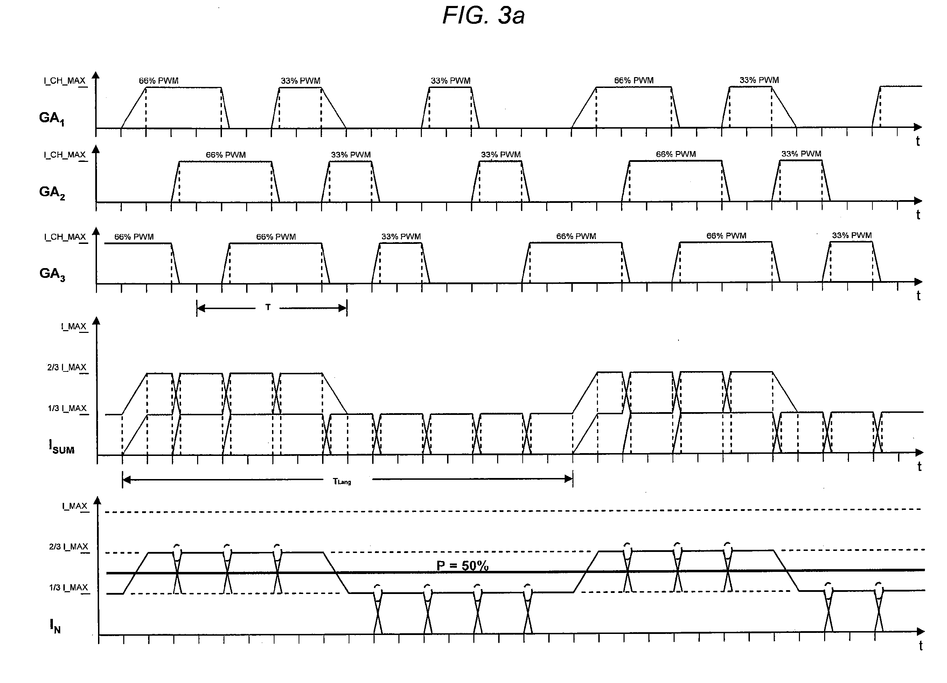

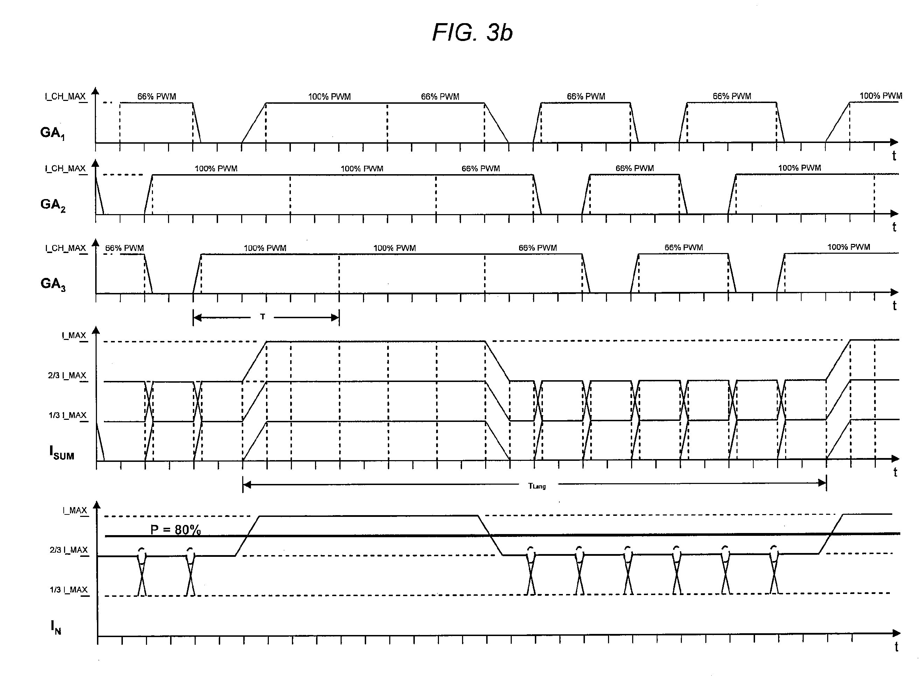

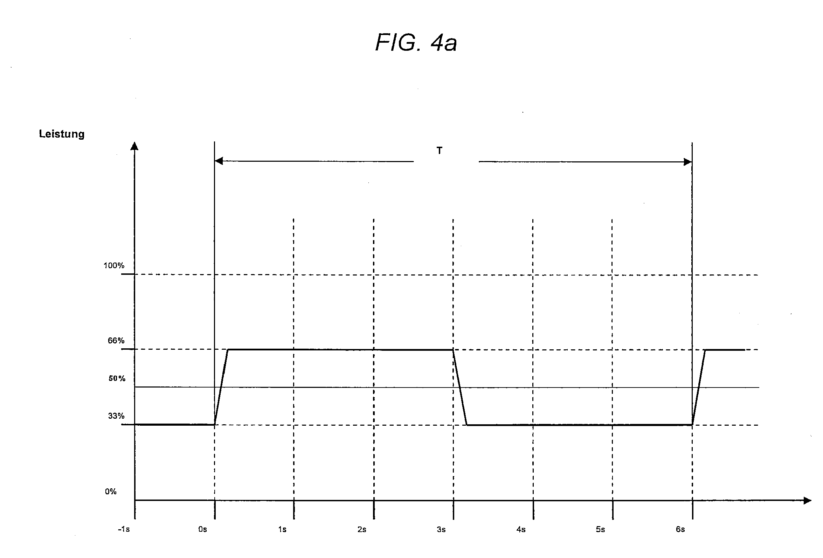

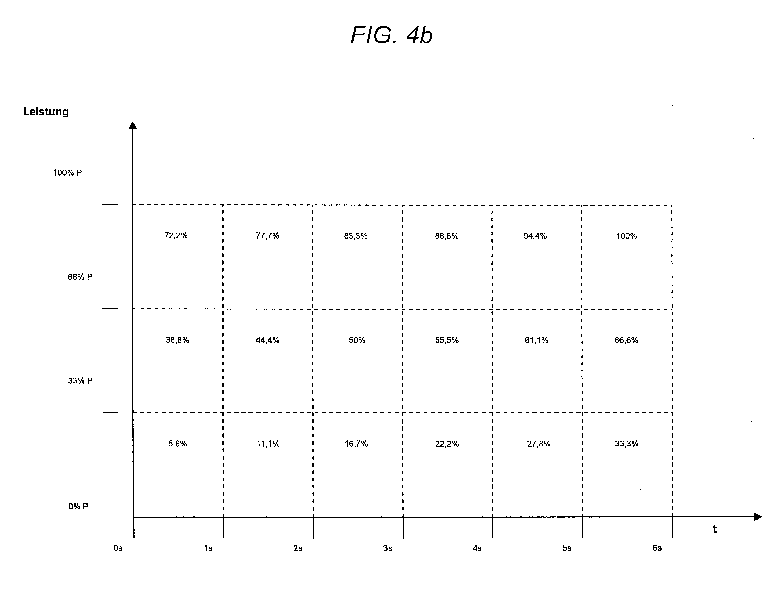

Obgleich bei den vorstehend gezeigten Ausführungsbeispielen der Erfindung eine Ansteuerung der Verbraucher in vorgegebenen diskreten Leistungsstufen vorgesehen ist, können gleichwohl nahezu beliebige andere prozentuelle Leistungswerte realisiert werden. Dies soll nachstehend anhand der Fig.3a, 3b, 4a und 4b näher erläutert werden.

Im Diagramm der Fig. 3a ist eine Ansteuerung dargestellt, bei der die Verbraucher zyklisch abwechselnd mit den Leistungswerten 66% und 33% angesteuert werden; hierdurch ergibt sich eine durchschnittliche Ansteuerungsleistung der Verbraucher von 50% (siehe die unterste Diagrammzeile). Im Diagramm der Fig. 3b ist eine alternative Ansteuerung dargestellt, bei der die Verbraucher zyklisch abwechselnd mit den Leistungswerten 66% und 100% derart angesteuert werden, dass sich schließlich eine durchschnittliche Ansteuerungsleistung der Verbraucher von 80% ergibt (siehe die unterste Diagrammzeile).

In Fig. 4a wird beispielhaft davon ausgegangen, dass die Taktfrequenz TF der PWM-Ansteuerung, also die der Leistung 100% entsprechende Impulsbreite, den Wert 1 Sekunde hat. Wenn dann innerhalb eines Regelungszeitraums T entsprechend 6 TF drei Mal die Leistungsstufe 66% und 3 Mal die Leistungsstufe 33% realisiert wird, ergibt sich im Mittel eine Leistung von 50%. Dieses Schema kann gemäß dem in Fig. 4b gezeigten Leistungsdiagramm so erweitert werden, dass insgesamt 19 Leistungsstufen (inklusive der Leistung 0%) mit den gezeigten prozentuellen Werten erreicht werden können, indem die jeweils geeignete Anzahl von diskreten Leistungswerten 0%, 33%, 66% und 100% in zyklischer Folge eingestellt wird. Wenn der Regelungszeitraum T auf mehr als 6 Taktzyklen erhöht wird, können noch mehr Leistungswerte erzielt werden, nämlich insgesamt (3 * TN) + 1, wenn mit TN die Anzahl der Taktzyklen innerhalb des Regelungszeitraum T bezeichnet ist.

Demgemäß ist es mit der Erfindung möglich, trotz der "Einschränkung" auf die durch die Anzahl der Verbraucher vorgegebenen diskreten Leistungsstufen sehr viele andere, zwischen den diskreten Stufen liegende Leistungswerte zu realisieren. Voraussetzung hierfür ist natürlich, dass es sich um Verbraucher handelt, die in der Lage sind, solche zeitlich schwankenden Leistungen zu verkraften. Dies ist beispielsweise bei Heizelementen der Fall.

Heizelemente haben aber aufgrund ihrer Widerstands/Temperatur-Kennlinie in der Praxis den Nachteil, dass sie bei ihrer Inbetriebnahme (also im kalten Zustand) mehr Strom ziehen, als dies ihrer Nennleistung im warmen Zustand entspricht. Würden derartige Heizelemente daher bei Inbetriebnahme sofort mit ihrer vollen Leistung angesteuert werden, hätte dies unter Umständen eine Überlastung des Energieversorgungsnetzes zur Folge. Eine solche Überlastung kann mit der Erfindung sehr einfach dadurch vermieden werden, dass bei der Inbetriebnahme der Heizelemente im kalten Zustand deren Leistung durch langsames Erhöhen der Schaltstufen geändert wird, um eine zu hohe Strombelastung des Energieversorgungsnetzes in dieser Kaltphase zu vermeiden. Beispielsweise könnte bei Inbetriebnahme die Ansteuerung für einen vorbestimmten Zeitraum mit niedrigen Leistungswerten von z.B. 33% erfolgen, bevor auf höhere Leistungswerte bzw. auf volle Leistung umgeschaltet wird. Ggf. kann es auch reichen, nur eines der Heizelemente bei Inbetriebnahme mit niedriger Leistung zu betreiben und die anderen sogleich mit voller Leistung. Die Ansteuerung sollte in jedem Fall so erfolgen, dass die Belastung des Energieversorgungsnetzes nie den vorgesehenen Maximalwert überschreitet.

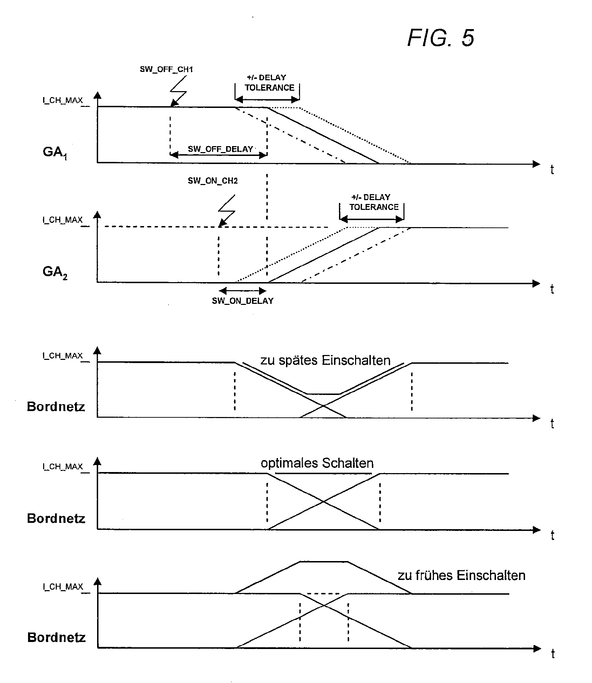

In Fig. 5 ist eine Ausführungsform der Erfindung gezeigt, bei der thermisch oder durch andere Einflüsse bedingte Änderungen der Ein- und Ausschaltverzögerung der verwendeten MOSFET-Schalter kompensiert werden können. Wie aus dieser Figur ersichtlich ist, werden die Einschalt- und/oder die Ausschaltverzögerungen der MOSFET-Schalter dynamisch überwacht und bei der Wahl ihres Einschalt- bzw. Ausschaltzeitpunkts so berücksichtigt, dass die von der Erfindung gewünschte Überlappung der Flanken möglichst synchron ist. Diese Art der Regelung kann z.B. softwareseitig dadurch erreicht werden, dass anhand der Mess-Signale U_{S} und/oder I_{S} der tatsächliche Stromverlauf überprüft und hieraus auf eine Ein- und/oder Ausschaltverzögerung geschlossen wird. Die Regelung kann auch durch entsprechende Hardware- bzw. Schaltungskomponenten erfolgen.

Bezüglich noch weiterer Merkmale und Vorteile der Erfindung wird ausdrücklich auf die Offenbarung der Figuren verwiesen.

### Bezugszeichenliste

- RH₁ - RH₃: Elektrischer Verbraucher (Heizelement)
- V_{S}: Energieversorgungsnetz (Bordnetz)
- I_{S}: Stromerfassungs-Signal
- GND: Massepotential
- MF₁- MF₃: Elektronische Schalteinrichtungen (z.B. Leistungs-MOSFET-Schalter)
- G: Gate
- S: Source
- D: Drain
- C_{G}: (parasitäre) Kapazität
- µC: Mikrocontroller
- R_{slow_1} R_{fast_1} R_{fast_2} R_{fast_3}: Vorwiderstände
- RS₁ - RS₃: Shuntwiderstände
- A₁ - A₃: Ausgangsanschlüsse
- GA_{1S}, GA_{1F},GA_{2F}, GA_{3F}: Individuelle Gate-Ansteuersignale
- I_{SUM}: Summenstrom
- I_{N}: Nennstrom
- TF: Taktfrequenz der PWM (Impulsbreite bei Leistung 100%)
- T: Regelungszeitraum

## Patentansprüche

1. Elektronisches Ansteuersystem zur Steuerung der Leistungsaufnahme von N (N >1) an ein gemeinsames Energieversorgungsnetz (V_{S}) angeschlossenen elektrischen Verbrauchern (RH₁ - RH₃), bei dem für jeden elektrischen Verbraucher (RH₁ - RH₃) eine eigene elektronische Schalteinrichtung (MF₁, MF₂, MF₃) vorgesehen ist, die die jeweilige Leistungsaufnahme des angeschlossenen Verbrauchers durch eine Pulsweitenmodulation (PWM) individuell steuert,
***dadurch gekennzeichnet, dass*** das Ansteuersystem
[a] die ansteigende Flanke der pulsweitenmodulierten Ausgangsspannung einer Schalteinrichtung (z.B. MF₁) jeweils mit der absteigenden Flanke der Ausgangsspannung einer anderen Schalteinrichtung (z.B. MF₂) synchronisiert,
[b] die Leistung der Verbraucher (RH₁ - RH₃) in N+1 diskreten Stufen regelt, nämlich in den Stufen 0%, 100% und N-1 Zwischenstufen (z.B. 33%, 66%), wobei die Pulsweite der Ausgangsspannung (Tastverhältnis) der jeweiligen Schalteinrichtungen (MF₁, MF₂, MF₃) in der **x**-ten Zwischenstufe (z.B. x=1, x=2) auf den Wert **(100/ N) * x %** eingestellt ist, und wobei der Phasenversatz: zwischen den **N** Schalteinrichtungen (MF₁, MF₂, MF₃) **360 / N** Grad beträgt, und
[c] solche prozentuelle Leistungswerte der Verbraucher (RH₁ - RH₃), die nicht den N+1 diskreten Stufen entsprechen, dadurch bereitstellt, dass es in zeitlicher Folge die diskreten Stufen so ändert, dass den Verbrauchern (RH₁ - RH₃) im zeitlichen Mittel die jeweils gewünschte prozentuelle Leistung zugeführt wird.

2. Elektronisches Ansteuersystem nach Anspruch 1, ***dadurch gekennzeichnet, dass*** das Ansteuersystem die sich im Betrieb - insbesondere durch thermische Einflüsse - ändernde Einschalt- und Ausschaltverzögerung der elektronischen Schalteinrichtungen (MF₁, MF₂, MF₃) dynamisch überwacht und bei der Wahl des Einschalt- bzw. Ausschaltzeitpunkts der jeweiligen Schalteinrichtung (MF₁, MF₂, MF₃) so berücksichtigt, dass die Überlappung der Flanken möglichst synchron ist.

3. Elektronisches Ansteuersystem nach Anspruch 1 oder 2, ***dadurch gekennzeichnet*, dass** mindestens eine der Schalteinrichtungen (MF₁, MF₂, MF₃) mit mindestens zwei verschiedenen Flankensteilheiten schaltbar ist, wobei das Ansteuersystem die Schaltvorgänge im Normalfall mit einer hohen Flankensteilheit (d.h. schneller) durchführt, während es einen Schaltvorgang zum Ändern einer Leistungsstufe mit einer niedrigen Flankensteilheit (d.h. langsamer) durchführt.

4. Elektronisches Ansteuersystem nach Anspruch 3, ***dadurch gekennzeichnet, dass*** nur eine einzige Schalteinrichtung (z.B. MF₁) vorgesehen ist, die mit mindestens zwei verschiedenen Flankensteilheiten schaltbar ist, wobei das Ansteuersystem das Ändern einer Leistungsstufe immer mit dieser einen Schalteinrichtung einleitet.

5. Elektronisches Ansteuersystem nach einem der Ansprüche 1 bis 4, ***dadurch gekennzeichnet*, *dass*** die Verbraucher elektrische Heizelemente (RH₁ - RH₃) sind, wobei das Ansteuersystem bei der Inbetriebnahme der Heizelemente (RH₁ - RH₃) im kalten Zustand deren Leistung durch langsames Erhöhen der Schaltstufen ändert, um eine zu hohe Strombelastung des Energieversorgungsnetzes (V_{S}) in dieser Kaltphase zu vermeiden.

6. Elektronisches Ansteuersystem nach Anspruch 5, ***dadurch gekennzeichnet, dass*** die elektrischen Heizelemente (RH₁ - RH₃) zusammen mit dem Ansteuersystem ein integriertes Heizmodul bilden.

7. Elektronisches Ansteuersystem nach einem der Ansprüche 1 bis 6, ***dadurch gekennzeichnet, dass*** die elektronischen Schalteinrichtungen als Leistungs-Halbleiter-Schalter (MF₁, MF₂, MF₃) ausgebildet sind.

8. Elektronisches Ansteuersystem nach Anspruch 7, ***dadurch gekennzeichnet, dass*** Leistungs-Halbleiter-Schalter (MF₁, MF₂, MF₃) MOSFET- oder IGBT-Schalter sind.

9. Elektronisches Ansteuersystem nach einem der Ansprüche 1 bis 8, ***dadurch gekennzeichnet, dass*** das Energieversorgungsnetz (V_{S}) Teil eines Bordnetzes eines Kraftfahrzeugs ist.

10. Verfahren zur Steuerung der Leistungsaufnahme von N (N > 1) an ein gemeinsames Energieversorgungsnetz (V_{S}) angeschlossenen elektrischen Verbrauchern (RH₁ - RH₃), bei dem die jeweilige Leistungsaufnahme des jeweils angeschlossenen Verbrauchers durch eine Pulsweitenmodulation (PWM) individuell gesteuert wird,
***dadurch gekennzeichnet, dass***
[a] die ansteigende Flanke der pulsweitenmodulierten Ausgangsspannung einer Schalteinrichtung (z.B. MF₁) jeweils mit der absteigenden Flanke der Ausgangsspannung einer anderen Schalteinrichtung (z.B. MF₂) synchronisiert wird,
[b] die Leistung der Verbraucher (RH₁ - RH₃) in N+1 diskreten Stufen geregelt wird, nämlich in den Stufen 0%, 100% und N-1 Zwischenstufen (z.B. 33%, 66%), wobei die Pulsweite der Ausgangsspannung (Tastverhältnis) der jeweiligen Schalteinrichtungen (MF₁, MF₂, MF₃) in der **x**-ten Zwischenstufe (z.B. x=1, x=2) auf den Wert **(1001 N) * x %** eingestellt wird, und wobei der Phasenversatz: zwischen den N Schalteinrichtungen (MF₁, **MF₂, MF₃) 360 / N** Grad beträgt, und
[c] solche prozentuelle Leistungswerte der Verbraucher (RH₁ - RH₃), die nicht den N+1 diskreten Stufen entsprechen, dadurch bereitgestellt werden, dass in zeitlicher Folge die diskreten Stufen so geändert werden, dass den Verbrauchern (RH₁ - RH₃) im zeitlichen Mittel die jeweils gewünschte prozentuelle Leistung zugeführt wird.

11. Verfahren nach Anspruch 10, ***dadurch gekennzeichnet, dass*** die sich im Betrieb - insbesondere durch thermische Einflüsse - ändernde Einschalt- und Ausschaltverzögerung von zur Ansteuerung verwendeten elektronischen Schalteinrichtungen (MF₁, MF₂, MF₃) dynamisch überwacht und bei der Wahl des Einschalt- bzw. Ausschaltzeitpunkts der jeweiligen Schalteinrichtung so berücksichtigt wird, dass die Überlappung der Flanken möglichst synchron bleibt.

12. Verfahren nach Anspruch 10 oder 11, ***dadurch gekennzeichnet, dass*** mindestens eine der zur Ansteuerung verwendeten Schalteinrichtungen (MF₁, MF₂, MF₃) mit mindestens zwei verschiedenen Flankensteilheiten schaltbar ist, wobei die Schaltvorgänge im Normalfall mit einer hohen Flankensteilheit (d.h. schneller) durchgeführt werden, während das Ändern einer Leistungsstufe mit einer niedrigen Flankensteilheit (d.h. langsamer) durchgeführt wird.

13. Verfahren nach Anspruch 12, ***dadurch gekennzeichnet, dass*** nur eine einzige Schalteinrichtung (z.B. MF₁) vorgesehen ist, die mit mindestens zwei verschiedenen Flankensteilheiten schaltbar ist, wobei das Ändern einer Leistungsstufe immer mit dieser einen Schalteinrichtung eingeleitet wird.
